(19) Europäisches Patentamt / European Patent Office / Office européen des brevets

(11) **EP 3 771 055 B1**

(12) **FASCICULE DE BREVET EUROPEEN**

(45) Date de publication et mention
de la délivrance du brevet:
**05.04.2023 Bulletin 2023/14**

(21) Numéro de dépôt: **20186394.1**

(22) Date de dépôt: **17.07.2020**

(51) Classification Internationale des Brevets (IPC):
*H02H 3/087* (2006.01)    *H02H 7/12* (2006.01)
*H02H 7/122* (2006.01)    *G01R 19/165* (2006.01)

(52) Classification Coopérative des Brevets (CPC):
**H02H 3/087; G01R 19/16538; H02H 7/1203;
H02H 7/1222; H02H 7/1227;** G01R 19/16571

(54) **DISPOSITIF DE DÉTECTION DE SUR-COURANT DANS UN CIRCUIT ÉLECTRIQUE DE PUISSANCE COMPRENANT UN DISPOSITIF DE FILTRAGE À RÉGIME DE CHARGE CONTRÔLÉ D'UN CONDONSATEUR**

GÜBERSTROM-ERKENNUNGSVORRICHTUNG IN EINEM ELEKTRISCHEN LEISTUNGSSCHALTKREIS UMFASSEND EINEN FILTER ZUR STEUERUNG DER LADUNG EINES KONDENSATORS

DEVICE FOR DETECTING OVERCURRENT IN AN ELECTRICAL POWER CIRCUIT COMPRISING A FILTERING MEANS CONTROLLING THE CHARGE OF A CAPACITOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.07.2019 FR 1908898**

(43) Date de publication de la demande:
**27.01.2021 Bulletin 2021/04**

(73) Titulaire: **NEXTER Systems
78034 Versailles Cedex (FR)**

(72) Inventeurs:
• **DECROUX, Philippe
  18023 Bourges CEDEX (FR)**
• **DEGOUTTE, Cédric
  18023 Bourges CEDEX (FR)**

(74) Mandataire: **Cabinet Chaillot
16/20, avenue de l'Agent Sarre
B.P. 74
92703 Colombes Cedex (FR)**

(56) Documents cités:
EP-A1- 3 086 131    CN-Y- 2 840 437
US-A- 3 974 430    US-A- 4 000 369

**Description**

La présente invention concerne le domaine des systèmes de mesure de courant pour circuit électrique de puissance, et porte en particulier sur un dispositif de détection de surcourant dans un circuit électrique de puissance et sur un ensemble circuit électrique de puissance - dispositif de détection de sur-courant.

Les contrôleurs de puissance à semi-conducteurs, aussi appelés SSPC (acronyme de leur dénomination anglo-saxonne « Solid State Power Controller »), ont pour but d'alimenter une charge en un courant avec des caractéristiques de tension et de puissance données. Ces SSPC permettent de commander l'ouverture de circuits fonctionnant avec des tensions importantes (de 12 Volts à 1000 Volts) et avec des intensités de quelques centaines d'ampères pendant la phase de fermeture et d'ouverture.

La chaîne de mesure des SSPC doit avoir un faible temps de réponse afin d'être en mesure d'ouvrir le réseau de puissance en cas de détection d'un court-circuit en aval. Les SSPC doivent également être insensibles aux transitoires de tension du réseau de puissance. En effet, lorsque la charge du SSPC est capacitive, un transitoire de tension sur le réseau a pour conséquence de générer un courant transitoire dans le SSPC avec un fort gradient, ce qui entraîne une charge du condensateur en aval du SSPC. Ce fort gradient a pour conséquence de solliciter la protection contre les courts-circuits du SSPC, et par voie de conséquence, de provoquer l'ouverture de celui-ci de façon inappropriée.

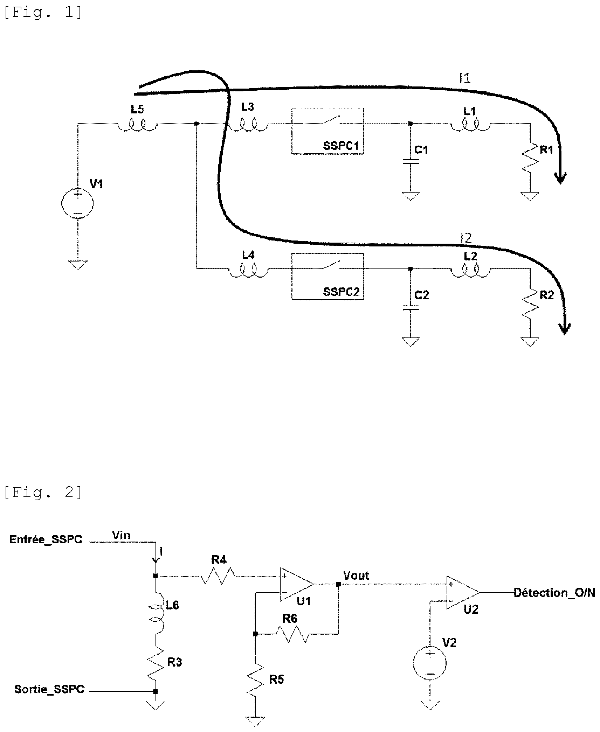

La Figure 1 représente un montage à titre d'exemple comprenant deux SSPC, à savoir SSPC1 et SSPC2. Les SSPC1 et SSPC2 peuvent être tout système assurant l'ouverture d'un courant sur le réseau électrique, tel qu'un disjoncteur ou un relais. La charge du SSPC1 comprend un condensateur C1 relié entre la sortie du SSPC1 et la masse, et une bobine d'inductance L1 et une résistance R1 reliées en série entre la sortie du SSPC1 et la masse. De la même manière, la charge du SSPC2 comprend un condensateur C2 relié entre la sortie du SSPC2 et la masse, et une bobine d'inductance L2 et une résistance R2 reliées en série entre la sortie du SSPC2 et la masse. Le montage de la Figure 1 comprend en outre une source de tension V1 en série avec une bobine d'inductance L5, l'entrée du SSPC1 étant reliée à la bobine d'inductance L5 par l'intermédiaire d'une bobine d'inductance L3, et l'entrée du SSPC2 étant reliée à la bobine d'inductance L5 par l'intermédiaire d'une bobine d'inductance L4. Les inductances L3, L4 et L5 représentent les inductances induites par les liaisons électriques. Il est communément admis (pour les circuits SSPC) qu'un mètre de liaison électrique correspond à une inductance de l'ordre de 1 micro Henry.

Lorsque les deux SSPC, à savoir SSPC1 et SSPC2, sont fermés, un courant I1 est établi dans la charge du SSPC1, et un courant I2 est établi dans la charge du SSPC2. En cas d'ouverture du SSPC1, pendant la phase d'extinction du courant I1, une surtension apparaît aux bornes de la bobine d'inductance L5, ladite surtension étant liée au ΔI/Δt du courant I1. Cette variation de tension provoque un surcourant dans le condensateur C2 relié au SSPC2. Ce surcourant peut alors être interprété, de façon erronée, comme l'apparition d'un court-circuit par le SSPC2.

Il est connu, dans l'état antérieur de la technique, de mesurer le courant circulant dans un circuit électrique à l'aide d'une résistance de shunt. A titre d'exemple, la Figure 2 représente un dispositif de détection de surcourant selon l'état antérieur de la technique. Ce dispositif de détection de sur-courant existant comprend une résistance de shunt R3 incorporée en série dans un circuit électrique de type contrôleur de puissance à semi-conducteurs (SSPC) entre une entrée du SSPC (Entrée_SSPC) et une sortie du SSPC (Sortie_SSPC), la sortie du SSPC (Sortie_SSPC) étant reliée à la masse du circuit. Une tension Vin est ainsi mesurée aux bornes de la résistance de shunt R3. La résistance de shunt R3 possède une inductance parasite L6 (de quelques nH), ce qui crée un circuit dérivateur. Le dispositif de détection de surcourant existant comprend en outre un premier amplificateur opérationnel U1 (utilisé en montage amplificateur) dont l'entrée non inverseuse est reliée à l'entrée du SSPC (Entrée_SSPC) par l'intermédiaire d'une résistance R4. Une résistance R5 est disposée entre l'entrée inverseuse du premier amplificateur opérationnel U1 et la masse, et une résistance R6 est disposée entre l'entrée inverseuse du premier amplificateur opérationnel U1 et la sortie du premier amplificateur opérationnel U1, le gain du premier amplificateur opérationnel U1 dépendant des valeurs des résistances R5 et R6, la tension (Vout) à la sortie du premier amplificateur opérationnel U1 étant l'image du courant aux bornes de la résistance de shunt R3. Le dispositif de détection de sur-courant existant comprend en outre un deuxième amplificateur opérationnel U2 (utilisé en montage comparateur) dont l'entrée non inverseuse est reliée à la sortie du premier amplificateur opérationnel U1 et dont l'entrée inverseuse est reliée à une source de tension de référence V2, la sortie (Détection_O/N) du deuxième amplificateur opérationnel U2 indiquant un surcourant dans la résistance de shunt R3, et donc dans le SSPC, lorsque la tension Vout à l'entrée non inverseuse du deuxième amplificateur opérationnel U2 est supérieure à la tension de référence fournie par la source de tension de référence V2.

On a donc les équations suivantes :

$$Vin = (R3 + L6 \cdot p)I$$

où I est le courant traversant la résistance de shunt R3 et p = j.ω, où j désigne l'unité imaginaire et ω désigne la pulsation en rad.s$^{-1}$, et

$$Vout = \left(1 + \frac{R6}{R5}\right)Vin$$

.

On obtient donc :

$$Vout = \left(1 + \frac{R6}{R5}\right)(R3 + L6 \cdot p)I$$

La tension de référence de la source de tension de référence V2 permet de définir le seuil de courant détecté. Dans la pratique, le terme inductif L6.p s'ajoute au terme résistif R3, donc plus le $\Delta I/\Delta t$ est important, plus la détection sera faite avec une valeur instantanée du courant qui sera faible.

Pour compenser la présence de l'inductance parasite L6 de la résistance de shunt R3, il est connu de placer un condensateur C3 (non représenté à la Figure 2) en parallèle de la résistance R6. On obtient alors

$$Vout = \left(1 + \frac{R6}{(1+R6.C3\,p)R5}\right) R3 \left(1 + \frac{L6}{R3}p\right)I .$$

Pour neutraliser l'influence de l'inductance parasite L6 de la résistance de shunt R3, la valeur dudit condensateur

$$C3 = \frac{L6}{R3 \cdot R6}$$

.

C3 doit donc prendre la valeur suivante:

Cependant, dans la pratique, cette solution est très difficile à mettre en œuvre. En effet, la bande passante de l'amplificateur opérationnel U1, la maîtrise de la valeur de l'inductance parasite L6, la nécessité d'ajuster la valeur du condensateur C3, les capacités parasites du montage et le comportement de l'amplificateur opérationnel U1 aux fortes variations du $\Delta V/\Delta t$ au niveau de son entrée non inverseuse font que ce dispositif de détection de surcourant existant reste sensible aux transitoires importants.

La demande de brevet européen EP3086131A1, la demande de brevet chinois CN2840437Y et le brevet américain US3974430A décrivent des dispositifs de détection de surcourant selon l'état antérieur de la technique.

La présente invention, telle que définie par le jeux des revendications ici-joint, vise à résoudre les inconvénients de l'état antérieur de la technique, en proposant un dispositif de détection de sur-courant dans un circuit électrique de puissance, ledit dispositif de détection de sur-courant comprenant une résistance de shunt, un étage amplificateur et un étage comparateur, ledit dispositif de détection de sur-courant comprenant en outre un dispositif de filtrage disposé entre l'étage amplificateur et l'étage comparateur, ce qui permet le filtrage des transitoires de courant dans la résistance de shunt, et donc dans le circuit électrique de puissance, tel qu'un contrôleur de puissance à semi-conducteurs, sans pénaliser la bande passante.

La présente invention a donc pour objet un dispositif de détection de sur-courant dans un circuit électrique de puissance, ledit dispositif de détection de sur-courant comprenant : une résistance de shunt configurée pour être reliée aux bornes du circuit électrique de puissance ; un étage amplificateur dont l'entrée est reliée à l'une des bornes de la résistance de shunt, l'étage amplificateur étant configuré de telle sorte que la tension de sortie de l'étage amplificateur est fonction du courant aux bornes de la résistance de shunt ; et un étage comparateur configuré pour comparer la tension de sortie de l'étage amplificateur à une tension de référence de manière à détecter un surcourant dans le circuit électrique de puissance, caractérisé par le fait que ledit dispositif de détection de sur-courant comprend en outre un dispositif de filtrage disposé entre l'étage amplificateur et l'étage comparateur, le dispositif de filtrage comprenant : une diode dont la cathode est reliée à la sortie de l'étage amplificateur et dont l'anode est reliée à l'entrée de l'étage comparateur ; un condensateur dont l'une des bornes est reliée à l'anode de la diode et dont l'autre des bornes est reliée à la masse ; et une source de courant reliée à l'anode de la diode et configurée pour générer un courant constant. Ainsi, lorsque la tension de sortie de l'étage amplificateur est supérieure à la tension de référence, l'étage comparateur détecte un sur-courant dans la résistance de shunt, et donc dans le circuit électrique de puissance relié à la résistance de shunt.

La détection d'un sur-courant dans la résistance de shunt indique un court-circuit dans le circuit électronique de puissance.

Le dispositif de filtrage permet de filtrer les signaux parasites à la sortie de l'étage amplificateur, tout en conservant une grande bande passante.

Le dispositif de filtrage permet ainsi le filtrage des transitoires de courant dans la résistance de shunt, c'est-à-dire dans le circuit électrique de puissance, sans pénaliser la bande passante. Ainsi, ceci permet d'éviter la sollicitation inappropriée de la protection contre les courts-circuits du circuit électrique de puissance.

Il est à noter que la résistance de shunt pourrait également être la résistance drain-source à l'état passant (couramment appelée $R_{ON}$) d'un transistor à semi-conducteurs de type MOS monté aux bornes du circuit électrique de puissance, sans s'écarter du cadre de la présente invention.

Le dispositif de filtrage permet de neutraliser les signaux parasites à la sortie de l'étage amplificateur à l'aide d'un filtrage basé sur la charge d'un condensateur à l'aide d'un courant constant, tout en conservant une grande bande passante (voire conserver la fonction dérivateur induite par la résistance de shunt pour garder la sensibilité aux fortes variations de courant).

Grâce au dispositif de filtrage, si la sortie Vout de l'étage amplificateur augmente rapidement, l'entrée de l'étage

$$\frac{\Delta V}{\Delta t} = \frac{I10}{C10}$$

comparateur verra un signal limité par la pente définie comme suit:  , où I10 désigne le courant constant fournie par la source de courant du dispositif de filtrage et où C10 désigne le condensateur du dispositif de filtrage.

En outre, si la sortie Vout de l'étage amplificateur diminue rapidement, alors l'entrée de l'étage comparateur sera l'image du signal Vout plus la tension de seuil (0,6V) de la diode du dispositif de filtrage.

Il est à noter que la capacité parasite de la diode du dispositif de filtrage doit être négligeable par rapport au condensateur du dispositif de filtrage.

Selon une caractéristique particulière de l'invention, l'étage amplificateur comprend : un premier amplificateur opérationnel dont la sortie correspond à la sortie de l'étage amplificateur et dont l'entrée non inverseuse correspond à l'entrée de l'étage amplificateur ; une première résistance disposée entre l'entrée inverseuse du premier amplificateur opérationnel et la masse ; et une deuxième résistance disposée entre l'entrée inverseuse du premier amplificateur opérationnel et la sortie du premier amplificateur opérationnel, le gain du premier amplificateur opérationnel dépendant des valeurs des première et deuxième résistances, la tension à la sortie du premier amplificateur opérationnel étant l'image du courant aux bornes de la résistance de shunt.

Ainsi, le premier amplificateur opérationnel permet d'amplifier la tension présente sur son entrée inverseuse, c'est-à-dire aux bornes de la résistance de shunt. Le choix des valeurs des première et deuxième résistances permet de définir le gain du premier amplificateur opérationnel, ledit gain étant choisi en fonction de la plage de tension souhaitée à la sortie du premier amplificateur opérationnel.

Selon une caractéristique particulière de l'invention, l'étage amplificateur comprend en outre une troisième résistance disposée entre l'entrée de l'étage amplificateur et l'entrée non inverseuse du premier amplificateur opérationnel.

Ainsi, la troisième résistance en amont de l'entrée non inverseuse du premier amplificateur opérationnel permet, pour des applications dont la tension du réseau de puissance est inférieure à 200V, de contenir un courant de fuite.

Selon une caractéristique particulière de l'invention, l'étage comparateur comprend : un deuxième amplificateur opérationnel dont la sortie correspond à la sortie de l'étage comparateur et dont l'entrée non inverseuse correspond à l'entrée de l'étage comparateur ; et une source de tension de référence reliée à l'entrée inverseuse du deuxième amplificateur opérationnel et configurée pour générer la tension de référence, la sortie du deuxième amplificateur opérationnel indiquant un sur-courant dans la résistance de shunt lorsque la tension à l'entrée non inverseuse du deuxième amplificateur opérationnel est supérieure à la tension de référence.

Ainsi, l'étage comparateur permet de détecter un surcourant dans la résistance de shunt lorsque la tension à l'entrée non inverseuse du deuxième amplificateur opérationnel est supérieure à la tension de référence. Pour un courant $I_{initial}$ donné traversant la résistance de shunt, toute variation du courant inférieure à $\Delta t$, tel que défini ci-dessous, ne provoquera pas de détection de la part du deuxième amplificateur opérationnel :

$$\Delta t = \left( V2 - 0{,}6 - \left( R3 \cdot I_{initial} \right)\left( 1 + \frac{R6}{R5} \right) \right)\frac{C10}{I10}$$

.

Le dispositif de détection de sur-courant selon l'invention peut être utilisé dans tous les montages nécessitant de détecter un niveau de courant avec un très faible temps de réponse. Il est particulièrement adapté pour des seuils de courant supérieurs à 100A.

Le dispositif de détection de sur-courant selon l'invention est en outre particulièrement adapté pour se prémunir des transitoires de courant induits par des disjonctions ou des ouvertures d'un réseau électrique en charge (l'ouverture brutale d'un circuit électrique en charge provoquant des surtensions sur le réseau qui induisent des variations brutales des courants dans les charges encore présentes). La présente invention a en outre pour objet un ensemble circuit électrique de puissance - dispositif de détection de sur-courant, comprenant un circuit électrique de puissance et un dispositif de détection de sur-courant tel que décrit ci-dessus.

Ainsi, le dispositif de détection de sur-courant, relié aux bornes du circuit électrique de puissance, permet de détecter un sur-courant dans le circuit électrique de puissance, tout en étant insensible aux transitoires de courant dans celui-ci.

Selon une caractéristique particulière de l'invention, le circuit électrique de puissance est l'un parmi un contrôleur de puissance à semi-conducteurs et un onduleur. Dans le cas des contrôleurs de puissance à semi-conducteurs (SSPC), le dispositif de détection de sur-courant permet de gérer la fermeture du contact de puissance sur une charge capacitive sans induire de disjonction (association d'un temps de réponse très faible avec une protection contre les transitoires faiblement énergétiques).

Pour mieux illustrer l'objet de la présente invention, on va en décrire ci-après, à titre illustratif et non limitatif, un mode de réalisation préféré, avec référence aux dessins annexés.

Sur ces dessins :

- [Fig. 1] représente un montage à titre d'exemple de deux SSPC en parallèle ;
- [Fig. 2] représente un schéma fonctionnel d'un dispositif de détection de sur-courant selon l'état antérieur de la technique ; et
- [Fig. 3] représente un schéma fonctionnel d'un dispositif de détection de sur-courant selon la présente invention.

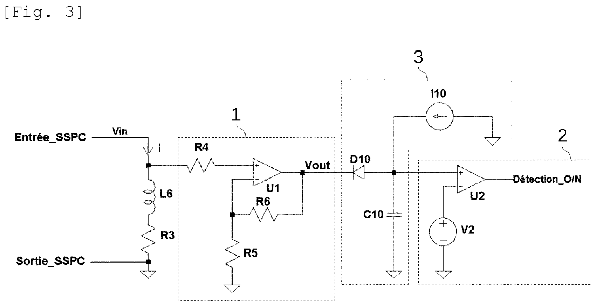

Si l'on se réfère à la Figure 3, on peut voir qu'il y est représenté un dispositif de détection de sur-courant selon la présente invention.

Le dispositif de détection de sur-courant selon la présente invention comprend une résistance de shunt R3 possédant une inductance parasite L6, ladite résistance de shunt R3 étant incorporée en série dans un circuit électrique de puissance de type SSPC entre une entrée du SSPC (Entrée_SSPC) et une sortie du SSPC (Sortie_SSPC), la sortie du SSPC (Sortie_SSPC) étant reliée à la masse. Une tension Vin est ainsi mesurée aux bornes de la résistance de shunt R3.

La résistance de shunt R3 est un composant discret de type résistance, mais pourrait également être la résistance drain-source à l'état passant (couramment appelée $R_{ON}$) d'un transistor à semi-conducteurs de type MOS, sans s'écarter du cadre de la présente invention.

Le dispositif de détection de sur-courant selon l'invention comprend en outre un étage amplificateur 1 dont l'entrée est reliée à l'entrée du SSPC (Entrée_SSPC), l'étage amplificateur 1 étant configuré de telle sorte que la tension de sortie de l'étage amplificateur 1 est fonction du courant I traversant la résistance de shunt R3.

L'étage amplificateur 1 comprend : un premier amplificateur opérationnel U1 dont la sortie correspond à la sortie de l'étage amplificateur 1, une première résistance R5 disposée entre l'entrée inverseuse du premier amplificateur opérationnel U1 et la masse, une deuxième résistance R6 disposée entre l'entrée inverseuse du premier amplificateur opérationnel U1 et la sortie du premier amplificateur opérationnel U1, et une troisième résistance R4 disposée entre l'entrée de l'étage amplificateur 1 et l'entrée non inverseuse du premier amplificateur opérationnel U1.

Le gain du premier amplificateur opérationnel U1 est fonction des valeurs des première et deuxième résistances R5 et R6, la tension à la sortie du premier amplificateur opérationnel U1 étant l'image du courant aux bornes de la résistance de shunt R3.

La troisième résistance R4 en amont de l'entrée non inverseuse du premier amplificateur opérationnel U1 permet, pour des applications dont la tension du réseau de puissance est inférieure à 200V, de contenir un courant de fuite.

Le dispositif de détection de sur-courant selon l'invention comprend en outre un étage comparateur 2 configuré pour comparer la tension de sortie de l'étage amplificateur 1 à une tension de référence de manière à détecter un surcourant (c'est-à-dire un court-circuit) dans le circuit électrique de puissance SSPC.

L'étage comparateur 2 comprend : un deuxième amplificateur opérationnel U2 dont la sortie correspond à la sortie de l'étage comparateur 2 et dont l'entrée non inverseuse correspond à l'entrée de l'étage comparateur 2, et une source de tension de référence V2 reliée à l'entrée inverseuse du deuxième amplificateur opérationnel U1 et configurée pour générer la tension de référence, la sortie (Détection_O/N) du deuxième amplificateur opérationnel U2 indiquant un sur-courant dans la résistance de shunt R3 lorsque la tension à l'entrée non inverseuse du deuxième amplificateur opérationnel U2 est supérieure à la tension de référence fournie par V2.

Le dispositif de détection de sur-courant selon l'invention comprend en outre un dispositif de filtrage 3 disposé entre l'étage amplificateur 1 et l'étage comparateur 2.

Le dispositif de filtrage 3 comprend : une diode D10 dont la cathode est reliée à la sortie du premier amplificateur opérationnel U1 et dont l'anode est reliée à l'entrée non inverseuse du deuxième amplificateur opérationnel U2, un condensateur C10 dont l'une des bornes est reliée à l'anode de la diode D10 et dont l'autre des bornes est reliée à la masse, et une source de courant I10 reliée à l'anode de la diode D10 et configurée pour générer un courant constant.

Le dispositif de filtrage 3 permet ainsi de filtrer les transitoires de tension à la sortie du premier amplificateur opérationnel U1 à l'aide d'un filtrage basé sur la charge du condensateur C10 à l'aide de la source de courant I10, tout en conservant une grande bande passante (voire conserver la fonction dérivateur induite par la résistance de shunt R3 pour garder la sensibilité aux fortes variations de courant). Ceci permet ainsi d'éviter la sollicitation inappropriée de la protection contre les courts-circuits du SSPC.

Le dispositif de filtrage 3 permet ainsi le filtrage des transitoires de courant dans la résistance de shunt R3, sans pénaliser la bande passante.

Grâce au dispositif de filtrage 3, si la tension de sortie (Vout) de l'étage amplificateur 1 augmente rapidement,

$$\frac{\Delta V}{\Delta t} = \frac{I10}{C10}$$

l'entrée de l'étage comparateur 2 verra un signal limité par la pente définie comme suit : .

En outre, si la tension de sortie (Vout) de l'étage amplificateur 1 diminue rapidement, alors l'entrée de l'étage comparateur 2 sera l'image de la tension Vout plus la tension de seuil (0,6V) de la diode D10 du dispositif de filtrage 3.

Il est à noter que la capacité parasite de la diode D10 doit être négligeable par rapport au condensateur C10 du dispositif de filtrage 3.

Pour un courant $I_{initial}$ donné traversant la résistance de shunt R3, toute variation du courant inférieure à $\Delta t$, tel que défini ci-dessous, ne provoquera pas de détection de la part de l'étage comparateur 2 :

$$\Delta t = \left( V2 - 0,6 - \left( R3 \cdot I_{initial} \right) \left( 1 + \frac{R6}{R5} \right) \right) \frac{C10}{I10}$$

.

Dans le cas de la survenue d'un gradient de courant I aux bornes de la résistance de shunt R3, une variation de la tension Vin, liée à l'influence de l'inductance parasite L6, se produit. Cette variation est présente en sortie Vout du premier amplificateur opérationnel U1. Le signal Vout est filtré par le dispositif de filtrage 3 comprenant I10 et C10, ce qui entraîne une limitation de la pente du signal à l'entrée de l'étage comparateur 2, de manière à ne pas générer de fausse détection.

Le dispositif de détection de sur-courant selon l'invention peut être utilisé dans tous les montages nécessitant de détecter un niveau de courant avec un très faible temps de réponse. Il est particulièrement adapté pour des seuils de courant supérieurs à 100A.

Le dispositif de détection de sur-courant selon l'invention est en outre particulièrement adapté pour se prémunir des transitoires de courant induits par des disjonctions ou des ouvertures d'un réseau électrique en charge (l'ouverture brutale d'un circuit électrique en charge provoquant des surtensions sur le réseau qui induisent des variations brutales des courants dans les charges encore présentes). La présente invention a en outre pour objet un ensemble circuit électrique de puissance - dispositif de détection de sur-courant, comprenant un circuit électrique de puissance, tel qu'un SSPC ou un onduleur, et un dispositif de détection de sur-courant tel que représenté à la Figure 3.

Dans le cas des SSPC, le dispositif de détection de surcourant selon l'invention permet de gérer la fermeture du contact de puissance sur une charge capacitive sans induire de disjonction (association d'un temps de réponse très faible avec une protection contre les transitoires faiblement énergétiques).

Il est bien entendu que le mode de réalisation particulier qui vient d'être décrit a été donné à titre indicatif et non limitatif, et que des modifications peuvent être apportées sans que l'on s'écarte pour autant de la présente invention.

**Revendications**

1.    - Dispositif de détection de sur-courant dans un circuit électrique de puissance, ledit dispositif de détection de sur-courant comprenant : une résistance de shunt (R3) configurée pour être reliée aux bornes du circuit électrique de puissance ; un étage amplificateur (1) dont l'entrée est reliée à l'une des bornes de la résistance de shunt (R3), l'étage amplificateur (1) étant configuré de telle sorte que la tension de sortie de l'étage amplificateur (1) est fonction du courant aux bornes de la résistance de shunt (R3) ; et un étage comparateur (2) configuré pour comparer la tension de sortie de l'étage amplificateur (1) à une tension de référence de manière à détecter un sur-courant dans le circuit électrique de puissance, **caractérisé par le fait que** ledit dispositif de détection de sur-courant comprend en outre un dispositif de filtrage (3) disposé entre l'étage amplificateur (1) et l'étage comparateur (2), le dispositif de filtrage (3) comprenant : une diode (D10) dont la cathode est reliée à la sortie de l'étage amplificateur (1) et dont l'anode est reliée à l'entrée de l'étage comparateur (2) ; un condensateur (C10) dont l'une des bornes est reliée à l'anode de la diode (D10) et dont l'autre des bornes est reliée à la masse ; et une source de courant (I10) reliée à l'anode de la diode (D10) et configurée pour générer un courant constant.

**2.** - Dispositif de détection de sur-courant selon la revendication 1, **caractérisé par le fait que** l'étage amplificateur (1) comprend : un premier amplificateur opérationnel (U1) dont la sortie correspond à la sortie de l'étage amplificateur (1) et dont l'entrée non inverseuse correspond à l'entrée de l'étage amplificateur (1) ; une première résistance (R5) disposée entre l'entrée inverseuse du premier amplificateur opérationnel (U1) et la masse ; et une deuxième résistance (R6) disposée entre l'entrée inverseuse du premier amplificateur opérationnel (U1) et la sortie du premier amplificateur opérationnel (U1), le gain du premier amplificateur opérationnel (U1) dépendant des valeurs des première et deuxième résistances (R5, R6), la tension à la sortie du premier amplificateur opérationnel (U1) étant l'image du courant aux bornes de la résistance de shunt (R3).

**3.** - Dispositif de détection de sur-courant selon la revendication 2, **caractérisé par le fait que** l'étage amplificateur (1) comprend en outre une troisième résistance (R4) disposée entre l'entrée de l'étage amplificateur (1) et l'entrée non inverseuse du premier amplificateur opérationnel (U1).

**4.** - Dispositif de détection de sur-courant selon l'une des revendications 1 à 3, **caractérisé par le fait que** l'étage comparateur (2) comprend : un deuxième amplificateur opérationnel (U2) dont la sortie correspond à la sortie de l'étage comparateur (2) et dont l'entrée non inverseuse correspond à l'entrée de l'étage comparateur (2) ; et une source de tension de référence (V2) reliée à l'entrée inverseuse du deuxième amplificateur opérationnel (U2) et configurée pour générer la tension de référence, la sortie du deuxième amplificateur opérationnel (U2) indiquant un sur-courant dans la résistance de shunt (R3) lorsque la tension à l'entrée non inverseuse du deuxième amplificateur opérationnel (U2) est supérieure à la tension de référence.

**5.** - Ensemble circuit électrique de puissance - dispositif de détection de sur-courant, comprenant un circuit électrique de puissance et un dispositif de détection de sur-courant selon l'une des revendications 1 à 4.

**6.** - Ensemble selon la revendication 5, **caractérisé par le fait que** le circuit électrique de puissance est l'un parmi un contrôleur de puissance à semi-conducteurs et un onduleur.

**Patentansprüche**

**1.** - Überstrom-Erkennungsvorrichtung in einem elektrischen Leistungsschaltkreis, wobei die Überstrom-Erkennungsvorrichtung Folgendes umfasst: einen Shunt-Widerstand (R3), der konfiguriert ist, um mit den Klemmen des elektrischen Leistungsschaltkreises verbunden zu sein; eine Verstärkerstufe (1), deren Eingang mit einer der Klemmen des Shunt-Widerstands (R3) verbunden ist, wobei die Verstärkerstufe (1) derart konfiguriert ist, dass die Ausgangsspannung der Verstärkerstufe (1) eine Funktion des Stroms an den Klemmen des Shunt-Widerstands (R3) ist; und eine Vergleichsstufe (2), die konfiguriert ist, um die Ausgangsspannung der Verstärkerstufe (1) mit einer Referenzspannung zu vergleichen, um einen Überstrom im elektrischen Leistungsschaltkreis zu erkennen, **dadurch gekennzeichnet, dass** die Überstrom-Erkennungsvorrichtung außerdem einen Filter (3) umfasst, der zwischen der Verstärkerstufe (1) und der Vergleichsstufe (2) angeordnet ist, wobei der Filter (3) Folgendes umfasst: eine Diode (D10), deren Kathode mit dem Ausgang der Verstärkerstufe (1) verbunden ist, und deren Anode mit dem Eingang der Vergleichsstufe (2) verbunden ist; einen Kondensator (C10), von dem die eine der Klemmen mit der Anode der Diode (D10) verbunden ist, und von dem die andere der Klemmen mit der Masse verbunden ist; und eine Stromquelle (I10), die mit der Anode der Diode (D10) verbunden und konfiguriert ist, um einen konstanten Strom zu erzeugen.

**2.** - Überstrom-Erkennungsvorrichtung nach Anspruch 1, **dadurch gekennzeichnet, dass** die Verstärkerstufe (1) Folgendes umfasst: einen ersten Operationsverstärker (U1), dessen Ausgang dem Ausgang der Verstärkerstufe (1) entspricht, und dessen nichtinvertierender Eingang dem Eingang der Verstärkerstufe (1) entspricht; einen ersten Widerstand (R5), der zwischen dem invertierenden Eingang des ersten Operationsverstärkers (U1) und der Masse angeordnet ist; und einen zweiten Widerstand (R6) der zwischen dem invertierenden Eingang des ersten Operationsverstärkers (U1) und dem Ausgang des ersten Operationsverstärkers (U1) angeordnet ist, wobei die Verstärkung des ersten Operationsverstärkers (U1) von den Werten des ersten und zweiten Widerstands (R5, R6) abhängt, wobei die Spannung am Ausgang des ersten Operationsverstärkers (U1) dem Strom an den Klemmen des Shunt-Widerstrands (R3) entspricht.

**3.** - Überstrom-Erkennungsvorrichtung nach Anspruch 2, **dadurch gekennzeichnet, dass** die Verstärkerstufe (1) außerdem einen dritten Widerstand (R4) umfasst, der zwischen dem Eingang der Verstärkerstufe (1) und dem nicht invertierenden Eingang des ersten Operationsverstärkers (U1) angeordnet ist.

4. - Überstrom-Erkennungsvorrichtung nach einem der Ansprüche 1 bis 3, **dadurch gekennzeichnet, dass** die Vergleichsstufe (2) Folgendes umfasst: einen zweiten Operationsverstärker (U2), dessen Ausgang dem Ausgang der Verstärkerstufe (2) entspricht, und dessen nicht invertierender Eingang dem Eingang der Vergleichsstufe (2) entspricht; und eine Referenzspannungsquelle (V2), die mit dem invertierenden Eingang des zweiten Operationsverstärkers (U2) verbunden und konfiguriert ist, um die Referenzspannung zu erzeugen, wobei der Ausgang des zweiten Operationsverstärkers (U2) einen Überstrom im Shunt-Widerstand (R3) anzeigt, wenn die Spannung am nicht invertierenden Eingang des zweiten Operationsverstärkers (U2) höher als die Referenzspannung ist.

5. - Einheit elektrischer Leistungsschaltkreis - Überstrom-Erkennungsvorrichtung, umfassend einen elektrischen Leistungsschaltkreis und eine Überstrom-Erkennungsvorrichtung nach einem der Ansprüche 1 bis 4.

6. - Einheit nach Anspruch 5, **dadurch gekennzeichnet, dass** der elektrische Leistungsschaltkreis einer von einem Leistungsregler mit Halbleitern und einem Wechselrichter ist.


**Claims**

1. - A device for detecting overcurrent in an electric power circuit, said overcurrent detection device comprising: a shunt resistor (R3) configured to be connected across the terminals of the electric power circuit; an amplifier stage (1) whose input is connected to one of the terminals of the shunt resistor (R3), the amplifier stage (1) being configured such that the output voltage of the amplifier stage (1) is a function of the current across the terminals of the shunt resistor (R3); and a comparator stage (2) configured to compare the output voltage of the amplifier stage (1) to a reference voltage so as to detect an overcurrent in the electric power circuit, **characterized in that** said overcurrent detection device further comprises a filtering device (3) arranged between the amplifier stage (1) and the comparator stage (2), the filtering device (3) comprising: a diode (D10) whose cathode is connected to the output of the amplifier stage (1) and whose anode is connected to the input of the comparator stage (2); a capacitor (C10) whereof one of the terminals is connected to the anode of the diode (D10) and whereof the other of the terminals is connected to the ground; and a current source (I10) connected to the anode of the diode (D10) and configured to generate a constant current.

2. - The overcurrent detection device according to claim 1, **characterized in that** the amplifier stage (1) comprises: a first operational amplifier (U1) whose output corresponds to the output of the amplifier stage (1) and whose non-inverting input corresponds to the input of the amplifier stage (1); a first resistor (R5) arranged between the inverting input of the first operational amplifier (U1) and the ground; and a second resistor (R6) arranged between the inverting input of the first operational amplifier (U1) and the output of the first operational amplifier (U1), the gain of the first operational amplifier (U1) depending on the values of the first and second resistors (R5, R6), the voltage at the output of the first operational amplifier (U1) being the image of the current across the terminals of the shunt resistor (R3).

3. - The overcurrent detection device according to claim 2, **characterized in that** the amplifier stage (1) further comprises a third resistor (R4) arranged between the input of the amplifier stage (1) and the non-inverting input of the first operational amplifier (U1).

4. - The overcurrent detection device according to one of claims 1 to 3, **characterized in that** the comparator stage (2) comprises: a second operational amplifier (U2) whose output corresponds to the output of the comparator stage (2) and whose non-inverting input corresponds to the input of the comparator stage (2); and a reference voltage source (V2) connected to the inverting input of the second operational amplifier (U2) and configured to generate the reference voltage, the output of the second operational amplifier (U2) indicating an overcurrent in the shunt resistor (R3) when the voltage at the non-inverting input of the second operational amplifier (U2) is greater than the reference voltage.

5. - An electric power current-overcurrent detection device assembly, comprising an electric power circuit and an overcurrent detection device according to one of claims 1 to 4.

6. - The assembly according to claim 5, **characterized in that** the electric power circuit is one of a semiconductor power controller and an inverter.

[Fig. 1]

[Fig. 2]

[Fig. 3]

**EP 3 771 055 B1**

## RÉFÉRENCES CITÉES DANS LA DESCRIPTION

**Documents brevets cités dans la description**

- EP 3086131 A1
- CN 2840437 Y
- US 3974430 A